# EUROPEAN PATENT SPECIFICATION

(11) **EP 1 276 322 B1**
(45) Date of publication and mention of the grant of the patent: **03.12.2003**
(21) Application number: 01116850.7
(22) Date of filing: 10.07.2001
(51) Int. Cl.: H04N 7/20, H04B 1/16

(54) **Satellite receiver and operation method**
Satellitenempfäger und Betriebsverfahren
Récepteur satellite et procédé de fonctionnement

(43) Date of publication of application: 15.01.2003
(73) Proprietor: Matsushita Electric Industrial Co., Ltd., Osaka 540-6319 (JP)
(72) Inventor: Scheid, Albrecht, Panasonic European, 63225 Langen (DE)
(74) Representative: Grünecker, Kinkeldey, Stockmair & Schwanhäusser Anwaltssozietät

(56) References cited:
- EP-A- 1 026 821
- US-A- 5 436 675
- US-A- 5 999 794
- SCHMEDT K ET AL: "KASKADIER-FAHIGER MULTISWITCH" RADIO FERNSEHEN ELEKTRONIK, VEB VERLAG TECHNIK. BERLIN, DE, vol. 43, no. 3, 1 March 1994 (1994-03-01), pages 22-23, XP000478260 ISSN: 1436-1574

## Description

The present invention relates to a satellite receiver and to a corresponding operation method, and in particular to a satellite receiver that can provide a power supply voltage to an external intermediate frequency signal generating device and that receives and amplifies the received intermediate frequency signal.

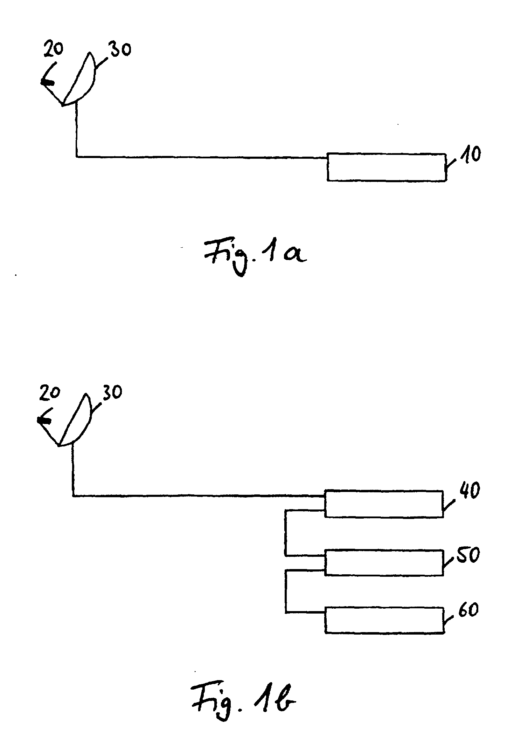

Satellite receivers are well known in the art. FIG. 1a shows diagrammatically a satellite reception system comprising a satellite receiver 10 which is connected to a satellite antenna. The antenna comprises a satellite converter block, named "Low Noise Block" (LNB) 20 and a parabolic reflector 30 that concentrates the received signal onto the LNB 20. The LNB converts the signal into an intermediate frequency IF signal which is transmitted through the cable connecting the antenna and the receiver 10. The receiver 10 selects a channel and demodulates the received signal for generating a video and/or audio signal.

As shown in FIG. 1b, there also exist satellite receivers 40-60 that can be operated in a cascade mode. For this purpose, the receivers are required to loop through the received IF signal so that the signal can be received by one of the other receivers in the cascade.

The satellite receivers shown in FIG.s 1a and 1b will now be described in more detail with reference to FIG.s 2a and 2b, respectively.

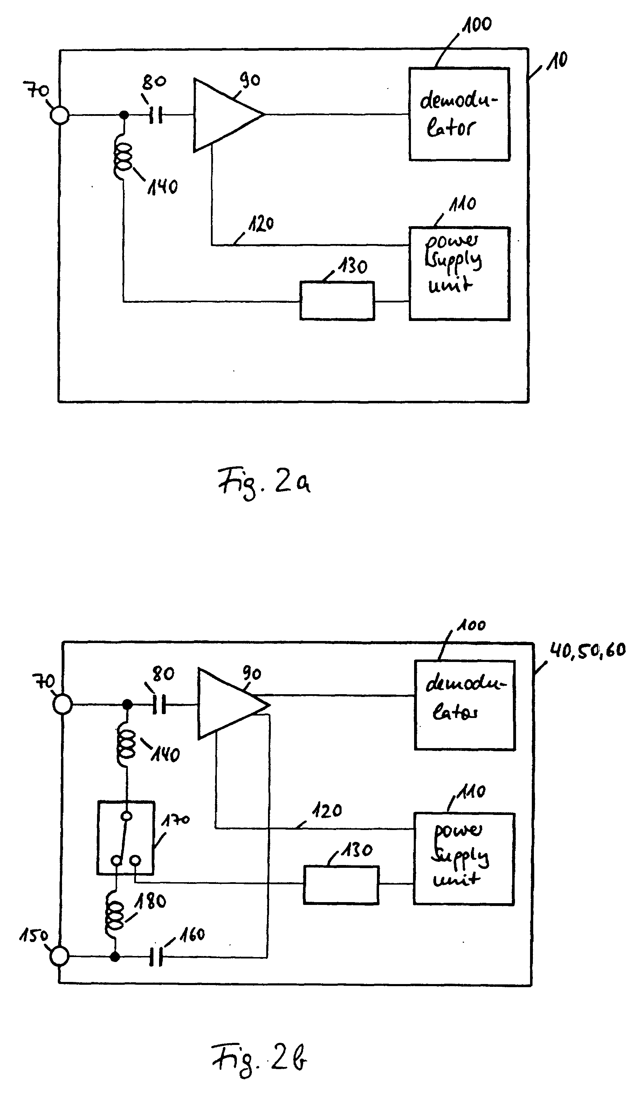

Referring to FIG. 2a which depicts a satellite receiver 10 that does not provide the mentioned IF loop-through feature, the IF signal is received at an antenna terminal 70 to which the LNB is connected via an antenna cable. The received IF signal is fed to an IF amplifier 90 that is coupled to the antenna terminal 70 by a capacitor 80. The IF amplifier 90 amplifies the received IF signal and provides the amplified signal to a demodulator 100 for processing the signal.

The receiver 10 further comprises a power supply unit 110 that provides a supply voltage to the IF amplifier 90 via supply line 120. The power supply unit 110 further generates a supply voltage to the LNB that is connected to the receiver. For this purpose the power supply unit 110 is connected to the antenna terminal 70 via a separate supply line. This line may include a tone burst generator 130 for adding a low voltage tone burst e.g. for sending DiSEqC commands to the LNB. Tone bursts are low voltage control words for LNB control containing modulated signalling words of frequency 22kHz and peak-to-peak voltage of 650mV, which are added to the LNB supply voltage. Further, there is provided an inductance 140 for de-coupling the received IF signal from the power supply unit 110 and the optional tone burst generator 130.

Referring now to FIG. 2b, a satellite receiver 40, 50, 60 having the loop-through feature differs from the receiver depicted in FIG. 2a in that there is an additional path provided for allowing the IF signal to go through to the following receivers. This path includes a second antenna terminal 150 to which the next satellite receiver is connected. The IF signal coming from the LNB enters the receiver via terminal 70 and is amplified by the IF amplifier 90. The amplified IF signal is then coupled to antenna terminal 150 via capacitance 160.

There may further be provided a circuitry for allowing the following receivers to supply a voltage to the LNB. This circuitry includes a switch 170 and an inductance 180 that de-couples the IF signal from the switch. If the switch 170 is in the position depicted in FIG.2b, the power supply voltage provided by any of the following satellite receivers through terminal 150 is passed through and output at terminal 70. Otherwise, i.e. the switch 170 is in the position where it connects the tone burst generator 130 and the inductance 140, the power supply unit 110 of the satellite receiver 40, 50, 60 is used for providing the LNB power supply voltage, in the same manner as in the receiver 10 shown in FIG. 2a.

The prior art satellite receivers, both without and with loop-through feature, have a significant power consumption when the satellite receiver is inoperative resulting in particular from the operation of the IF amplifier 90. Therefore, it is a need in the prior art to reduce the power consumption.

US 5,999,794 discloses a satellite receiver that can reduce power consumption when operated in loop-through configuration. The receiver comprises a circuit for detecting the presence and origin of a power supply voltage and transmits a power supply voltage to the IF amplifier from either the internal power supply unit or the terminal to which the following satellite receiver is connected. Thus, when the satellite receiver is inoperative and there is no voltage provided by the internal power supply unit, the power supply voltage at the terminal is used for feeding the IF amplifier. This allows for reducing the power consumption within the respective satellite receiver.

However, as will be understood by those of ordinary skill in the art, this prior art technique does in fact not really reduce the power consumption of the total system. While the presently inoperative satellite receiver does indeed no longer need to supply a voltage to the IF amplifier, this voltage is required to be produced in the following satellite receivers.

Further, the mentioned prior art technique is restricted to loop-through operative satellite receivers so that it cannot be used in receivers not having the capability of being cascaded.

In order to allow for an effective reduction of power consumption, it would therefore be desirable to turn off the IF amplifier 90 whenever IF amplification is not needed. When the satellite receiver is used without looping through the IF signal, the amplification of the IF signal can be considered as not being necessary if the satellite receiver is inoperative. However, when the satellite receiver is provided with the loop-through feature and operated in a cascade configuration, IF amplification is necessary as long as any of the following satellite receivers in the cascade is operative. Thus, for turning off the IF amplifier it is necessary to determine whether the present or any of the following satellite receivers is operative.

It is therefore the object of the invention to provide a satellite receiver and a corresponding operation method allowing for effectively reducing the power consumption and being suitable for use with both cascaded and stand alone satellite receivers.

This object is solved by the invention as claimed in the independent claims.

The invention makes use of the relationship between the power supply voltage for the IF signal generating device and the need for IF amplification in the satellite receiver. That is, the invention makes use of the fact that the presence of a supply voltage for the generating device indicates that the generating device is requested by the satellite receiver or any optionally connected satellite receiver to deliver an IF signal for demodulation. The absence of such a supply voltage indicates that an IF signal is currently not needed, e.g. because all satellite receivers in the cascade are currently in standby mode. Thus, the generating device supply voltage is used according to the present invention for switching the supply voltage of the IF amplifier.

Thus, as the present invention makes use of this close relationship between the supply voltage for the generating device and the need for the IF signal, one advantage of the present invention is that a standby circuit is provided that actually reduces the power consumption and that can be implemented using a simple circuit design. Since according to the invention the power supply voltage is detected there is no need for detecting signals in the intermediate frequency range.

Due to the simple circuit design, the invention provides a satellite receiver having a standby circuit that can be implemented cost effectively.

Another advantage of the present invention is that the satellite receiver can be operated independently on the software running inside the satellite receiver.

Preferred embodiments of the present invention are claimed in the dependent claims.

When the satellite receiver of the present invention is provided with the loop-through feature and the switching means is arranged for supplying a power supply voltage only from the internal power supply unit to the IF amplifier, this has the advantage that the receiver can operate stable. Contrary to the technique described in US 5,999,794, the satellite receiver is in this embodiment not provided with a power supply voltage for the IF amplifier from an external satellite receiver. Thus, any noise in the voltage from the external receivers cannot influence the operation of the IF amplifier. Further, there is no need for a voltage matching circuit if the external supply voltage (e.g. 13-18V) does not fit to the supply voltage of the IF amplifier (e.g. 5V ± 5%).

The invention will now be described in more detail with reference to the figure drawings, in which:
FIG. 1a illustrates a satellite reception system comprising a satellite receiver;
FIG. 1b illustrates a satellite reception system comprising a cascade of satellite receivers having the loop-through feature;
FIG. 2a illustrates a prior art satellite receiver not having the loop-through feature;
FIG. 2b illustrates a prior art satellite receiver having the loop-through feature;
FIG. 3a illustrates a preferred embodiment of a satellite receiver according to the present invention, not having the loop-through feature; and
FIG. 3b illustrates another preferred embodiment of a satellite receiver according to the present invention, having the loop-through feature.

The illustrative embodiments of the invention will be described with reference to the figure drawings wherein like elements and structures are indicated by like reference numbers.

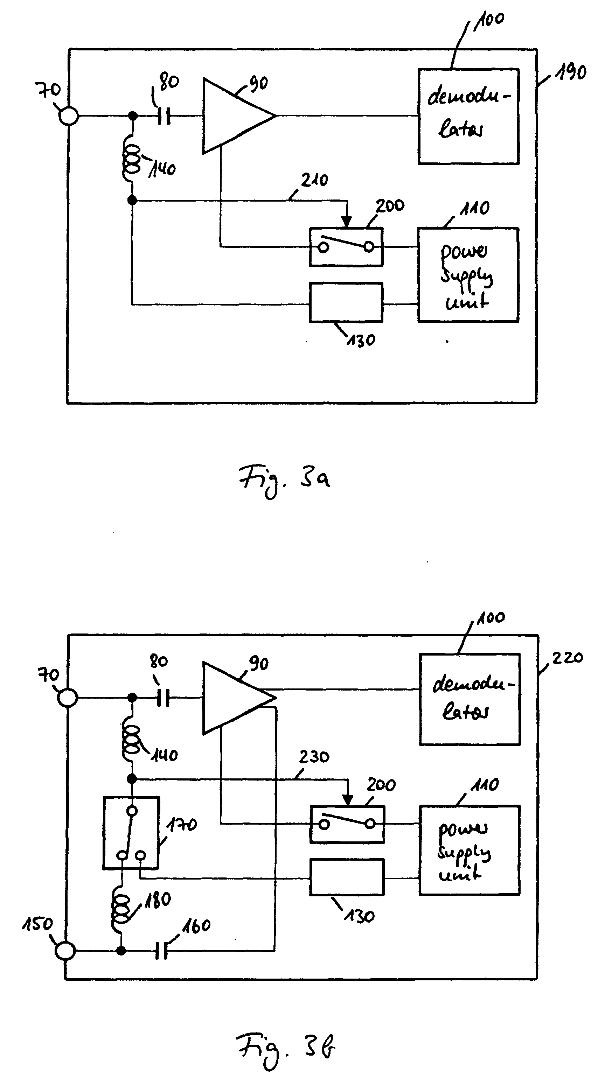

Referring now to the drawings and particularly to FIG. 3a, a preferred embodiment of a satellite receiver 190 is depicted. The satellite receiver 190 comprises a switch 200 for interrupting line 120. The switch is controlled by the power supply voltage that is generated by the power supply unit 110 for supplying the LNB connected to terminal 70. For this reason, the satellite receiver 190 comprises a control line 210 that supplies the switch 200 with the power supply voltage.

FIG. 3b shows another preferred embodiment of the invention. The shown satellite receiver 220 is provided with the loop-through feature for being cascaded with other external receivers. Further, a switch 200 is provided as described above in connection with FIG. 3a. The control voltage for operating the switch is taken from a point between the inductance 140 and the switch 170, via control line 230. Thus, switch 200 is controlled independently on whether the LNB supply voltage is provided by the internal power supply unit 110 or by an external satellite receiver connected to terminal 150.

Thus, in both embodiments the supply voltage for the LNB serves as control voltage for the control input of switch 200. Since the LNB needs a supply voltage to deliver an IF signal to the IF amplifier 90, as described above, this means that the supply voltage for the LNB is the indicator used for deciding whether to switch the supply voltage to the IF amplifier 90 or not.

Exemplarily, assuming that an external satellite receiver is connected to antenna terminal 150 of satellite receiver 220, the switch 170 selects the source which supplies the LNB. The position of switch 170 shown in FIG. 3b is used when satellite receiver 220 is inoperative. In this position, the external satellite receiver feeds the LNB via antenna terminal 150, inductance 180, switch 170, inductance 140 and antenna terminal 70. Shortly after the LNB gets its supply voltage it delivers an IF signal through the same antenna cable into the external satellite receiver via antenna terminal 70, capacitor 80, IF amplifier 90, capacitor 160 and antenna terminal 150. The LNB supply voltage that is present on control line 230 controls the switch 200 to feed the power supply voltage from unit 110 to the IF amplifier 90.

If all the receivers, satellite receiver 220 as well as any external satellite receiver, are in standby mode then there is no LNB supply voltage on control line 230 independent on the position of switch 170. In this case, the supply voltage for IF amplifier 90 is switched off as no IF amplification is required.

Since control line 230 receives the voltage from a point between inductance 140 and 170, the standby technique of the present invention functions also when the satellite receiver 220 takes over control of the LNB even when there are external receivers connected to terminal 150. If the satellite receiver 220 is to take over control of the LNB then switch 170 is set to the other position and the control of switch 200 works equivalently to the case of the satellite receiver 190 not being provided with the loop-through feature.

It will be appreciated by those of ordinary skill in the art that satellite receiver 220 does not allow an external satellite receiver provide a voltage supply to IF amplifier 90. Thus, no external satellite receiver is loaded excessively.

In a preferred embodiment, switch 200 is realised as an n-channel enhancement type MOS field effect transistor. This embodiment is preferred in particular when the supply voltage for the IF amplifier 90 (e.g. 5V) is several volts below the supply voltage for the LNB (e.g. 13-18V). Further, the MOS transistor preferably has a small on-resistance. When switch 200 is embodied as n-channel enhancement MOS field effect transistor, the LNB supply voltage is fed via control line 230 directly to the gate terminal, and the IF amplifier supply current flows through the channel of the MOS field effect transistor from the drain terminal to the source terminal of the transistor.

In another preferred embodiment switch 200 is a bipolar junction transistor that is connected to control line 210, 230 at its base terminal, and the supply current flows through the emitter of the transistor.

In an alternative preferred embodiment, the switch 200 is a relay. In this case, the LNB supply voltage is connected directly or by means of a resistive voltage divider network to the relay coil. The supply current flows through the relay switch.

As will be appreciated, the invention provides for an effective standby mode. On the transition from operation mode to standby mode the supply to the LNB is switched off by the power supply unit 110, and the optional tone burst from tone burst generator 130 is disabled. Because of the missing control voltage on control line 210, 230 the switch 200 will open, and the IF amplifier 90 is no longer supplied with a supply voltage. If the satellite receiver 190, 220 changes from standby mode to operation mode then the power supply unit 110 supplies power and the tone burst generator 130 may supply tone bursts to the LNB and thus the IF amplifier 90 is reactivated by the switch 200 which closes the connection between power supply unit 110 and the amplifier. Thus, all mode sensitive switching of the supply voltage to the IF amplifier is done automatically.

It will be appreciated by those of ordinary skill in the art that the satellite receivers 190, 220 of the present invention may be analog or digital receivers. Further, the invention has been described in combination with a LNB. It will however be appreciated that any satellite dish control appliance, distribution amplifier or similar appliances may be connected to antenna terminal 70 without departing from the invention.

## Claims

1. Satellite receiver comprising:
means (70, 110, 130, 150, 170) for providing a power supply voltage to an external intermediate frequency signal generating device;
means (70) for receiving an intermediate frequency signal from said generating device; and
an amplifier (90) for amplifying the received intermediate frequency signal;
**characterised by**
a standby circuit (200, 210, 230) for detecting whether a power supply voltage is provided to said generating device and for switching off said amplifier if no power supply voltage is provided to said generating device.

2. Satellite receiver according to claim 1, further **characterised by**:
means (150) for receiving a power supply voltage for said generating device from an external satellite receiver;
means (90, 150) for providing said intermediate frequency signal to the external satellite receiver; and
wherein said means for providing a power supply voltage to said generating device includes switch means (170) for selecting a power supply voltage generated by a power supply unit (110) of the satellite receiver, or a power supply voltage received from said external satellite receiver.

3. Satellite receiver according to claim 2, **characterised in that** said amplifier receives a power supply voltage from the power supply unit (110) of the satellite receiver if a power supply voltage is provided to said generating device.

4. Satellite receiver according to one of claims 1 to 3, **characterised in that**
said means for providing a power supply voltage to said generating device comprises a terminal (70);
said means for receiving an intermediate signal from said generating device comprises the same terminal (70); and
said terminal (70) is arranged for coupling the satellite receiver to a cable that is capable of transmitting both said power supply voltage and said intermediate frequency signal.

5. Satellite receiver according to one of claims 1 to 4, **characterised in that** said standby circuit comprises an n-channel enhancement MOS field effect transistor (200) for switching off said amplifier.

6. Satellite receiver according to one of claims 1 to 4, **characterised in that** said standby circuit comprises a bipolar junction transistor (200) for switching off said amplifier.

7. Satellite receiver according to one of claims 1 to 4, **characterised in that** said standby circuit comprises a relay (200) for switching off said amplifier.

8. Satellite receiver according to one of claims 1 to 7, **characterised in that** said generating device is a low noise block (LNB).

9. Satellite receiver according to one of claims 1 to 8, **characterised in that** the satellite receiver is an analog satellite receiver.

10. Satellite receiver according to one of claims 1 to 8, **characterised in that** said satellite receiver is a digital satellite receiver.

11. Method of operating a satellite receiver that can be connected to an intermediate frequency signal generating device for receiving an intermediate frequency signal therefrom, and that can provide a power supply voltage to said generating device, said satellite receiver comprising an amplifier for amplifying the received intermediate frequency signal, the method comprising the steps of:
detecting whether a power supply voltage is provided to said generating device; and
switching off said amplifier if no power supply voltage is provided to said generating device.

12. Method according to claim 11, arranged for operating a satellite receiver according to one of claims 1 to 10.

## Patentansprüche

1. Satellitenempfänger, der umfasst:
eine Einrichtung (70, 110, 130, 150, 170), die einer externen Zwischenfrequenzsignal-Erzeugungsvorrichtung eine Energieversorgungsspannung bereitstellt;
eine Einrichtung (70), die ein Zwischenfrequenzsignal von der Erzeugungsvorrichtung empfängt; und
einen Verstärker (90), der das empfangene Zwischenfrequenzsignal verstärkt;
**gekennzeichnet durch**:
eine Bereitschaftsschaltung (200, 210, 230), die erfasst, ob der Erzeugungsvorrichtung eine Energieversorgungsspannung bereitgestellt wird, und den Verstärker abschaltet, wenn der Erzeugungsvorrichtung keine Energieversorgungsspannung bereitgestellt wird.

2. Satellitenempfänger nach Anspruch 1, des Weiteren **gekennzeichnet durch**:
eine Einrichtung (150), die eine Energieversorgungsspannung für die Erzeugungsvorrichtung von einem externen Satellitenempfänger empfängt;
eine Einrichtung (90, 150), die dem externen Satellitenempfänger das Zwischenfrequenzsignal bereitstellt; und
wobei die Einrichtung, die der Erzeugungsvorrichtung eine Energieversorgungsspannung bereitstellt, eine Umschalteinrichtung (170) enthält, die eine Energieversorgungsspannung, die von einer Energieversorgungseinheit (110) des Satellitenempfängers erzeugt wird, oder eine Energieversorgungsspannung, die von dem externen Satellitenempfänger empfangen wird, auswählt.

3. Satellitenempfänger nach Anspruch 2, **dadurch gekennzeichnet, dass** der Verstärker eine Energieversorgungsspannung von der Energieversorgungseinheit (110) des Satellitenempfängers empfängt, wenn der Erzeugungsvorrichtung eine Energieversorgungsspannung bereitgestellt wird.

4. Satellitenempfänger nach einem der Ansprüche 1 bis 3, **dadurch gekennzeichnet, dass**:
die Einrichtung, die der Erzeugungsvorrichtung eine Energieversorgungsspannung bereitstellt, einen Anschluss (70) umfasst;
die Einrichtung, die ein Zwischensignal von der Erzeugungsvorrichtung empfängt, den gleichen Anschluss (70) umfasst; und
der Anschluss (70) so eingerichtet ist, dass er den Satellitenempfänger mit einem Kabel verbindet, das in der Lage ist, sowohl die Energieversorgungsspannung als auch das Zwischenfrequenzsignal zu übertragen.

5. Satellitenempfänger nach einem der Ansprüche 1 bis 4, **dadurch gekennzeichnet, dass** die Bereitschaftsschaltung einen N-Kanal-Anreicherungs-MOS-Feldeffekttransistor (200) zum Abschalten des Verstärkers umfasst.

6. Satellitenempfänger nach einem der Ansprüche 1 bis 4, **dadurch gekennzeichnet, dass** die Bereitschaftsschaltung einen Bipolar-Flächentransistor (200) zum Abschalten des Verstärkers umfasst.

7. Satellitenempfänger nach einem der Ansprüche 1 bis 4, **dadurch gekennzeichnet, dass** die Bereitschaftsschaltung ein Relais (200) zum Abschalten des Verstärkers umfasst.

8. Satellitenempfänger nach einem der Ansprüche 1 bis 7, **dadurch gekennzeichnet, dass** die Erzeugungsvorrichtung ein rauscharmer Verstärker (low noise block-LNB) ist.

9. Satellitenempfänger nach einem der Ansprüche 1 bis 8, **dadurch gekennzeichnet, dass** der Satellitenempfänger ein analoger Satellitenempfänger ist.

10. Satellitenempfänger nach einem der Ansprüche 1 bis 8, **dadurch gekennzeichnet, dass** der Satellitenempfänger ein digitaler Satellitenempfänger ist.

11. Verfahren zum Betreiben eines Satellitenempfängers, der mit einer Zwischenfrequenzsignal-Erzeugungsvorrichtung verbunden werden kann, um ein Zwischenfrequenzsignal von dieser zu empfangen, und der der Erzeugungsvorrichtung eine Energieversorgungsspannung bereitstellen kann, wobei der Satellitenempfänger einen Verstärker umfasst, der das empfangene Zwischenfrequenzsignal verstärkt, und das Verfahren die folgenden Schritte umfasst:
Erfassen, ob der Erzeugungsvorrichtung eine Energieversorgungsspannung bereitgestellt wird; und
Abschalten des Verstärkers, wenn der Erzeugungsvorrichtung keine Energieversorgungsspannung bereitgestellt wird.

12. Verfahren nach Anspruch 11, das zum Betreiben eines Satellitenempfängers nach einem der Ansprüche 1 bis 10 eingerichtet ist.

## Revendications

1. Récepteur satellite comprenant :
un moyen (70, 110, 130, 150, 170) destiné à délivrer une tension d'alimentation à un dispositif extérieur de génération de signal à fréquence intermédiaire ;
un moyen (70) destiné à recevoir un signal à fréquence intermédiaire dudit dispositif de génération ; et
un amplificateur (90) destiné à amplifier le signal à fréquence intermédiaire reçu,
**caractérisé par**
un circuit d'attente (200, 210, 230) destiné à détecter si une tension d'alimentation est ou non délivrée audit dispositif de génération et à couper ledit amplificateur si aucune tension d'alimentation n'est délivrée audit dispositif de génération.

2. Récepteur satellite selon la revendication 1,
**caractérisé en outre par** :
un moyen (150) destiné à recevoir d'un récepteur satellite extérieur une tension d'alimentation pour ledit dispositif de génération :
un moyen (90, 150) destiné à délivrer ledit signal à fréquence intermédiaire au récepteur satellite extérieur ; et
dans lequel ledit moyen destiné à délivrer une tension d'alimentation audit dispositif de génération comprend un moyen de commutation (170) destiné à sélectionner entre une tension d'alimentation générée par une unité d'alimentation (110) du récepteur satellite ou une tension d'alimentation reçue dudit récepteur satellite extérieur.

3. Récepteur satellite selon la revendication 2, **caractérisé en ce que** ledit amplificateur reçoit une tension d'alimentation de l'unité d'alimentation (110) du récepteur satellite si une tension d'alimentation est délivrée audit dispositif de génération.

4. Récepteur satellite selon l'une quelconque des revendications 1 à 3, **caractérisé en ce que** ledit moyen destiné à délivrer une tension d'alimentation audit dispositif de génération comprend une borne (70) ;
**en ce que** le moyen destiné à recevoir un signal intermédiaire dudit dispositif de génération comprend la même borne (70) ; et
**en ce que** ladite borne est disposée de manière à coupler le récepteur satellite à un câble qui est capable de transmettre à la fois ladite tension d'alimentation et ledit signal à fréquence intermédiaire.

5. Récepteur satellite selon l'une quelconque des revendications 1 à 4, **caractérisé en ce que** ledit circuit d'attente comprend un transistor MOS d'amélioration à effet de champ à n canaux (200) destiné à couper ledit amplificateur.

6. Récepteur satellite selon l'une quelconque des revendications 1 à 4, **caractérisé en ce que** ledit circuit d'attente comprend un transistor à jonction bipolaire (200) destiné à couper ledit amplificateur.

7. Récepteur satellite selon l'une quelconque des revendications 1 à 4, **caractérisé en ce que** ledit circuit d'attente comprend un relais (200) destiné à couper ledit amplificateur.

8. Récepteur satellite selon l'une quelconque des revendications 1 à 7, **caractérisé en ce que** ledit dispositif de génération est un bloc à faible bruit (LNB) .

9. Récepteur satellite selon l'une quelconque des revendications 1 à 8, **caractérisé en ce que** le récepteur satellite est un récepteur satellite analogique.

10. Récepteur satellite selon l'une quelconque des revendications 1 à 8, **caractérisé en ce que** le récepteur satellite est un récepteur satellite numérique.

11. Procédé de fonctionnement d'un récepteur satellite pouvant être relié à un dispositif de génération de signal à fréquence intermédiaire, destiné à recevoir de celui-ci un signal à fréquence intermédiaire, et pouvant délivrer une tension d'alimentation audit dispositif de génération, ledit récepteur satellite comprenant un amplificateur destiné à amplifier le signal à fréquence intermédiaire reçu, le procédé comprenant les étapes consistant à :
détecter si une tension d'alimentation est ou non fournie audit dispositif de génération ; et
à couper ledit amplificateur si aucune tension d'alimentation n'est fournie audit dispositif de génération.

12. Procédé selon la revendication 11, disposé pour faire fonctionner un récepteur satellite selon l'une quelconque des revendications 1 à 10.
